# EUROPEAN PATENT APPLICATION

(11) **EP 1 967 605 A1**
(43) Date of publication of application: **10.09.2008**
(21) Application number: 07004793.1
(22) Date of filing: 08.03.2007
(51) Int. Cl.: C23C 14/24, C23C 14/26

(54) **Evaporation tube and evaporation apparatus with adapted evaporation characteristic**

(71) Applicant: Applied Materials, Inc., Santa Clara, CA 95054 (US)
(72) Inventor: Aulbach, Holger, 63801 Kleinostheim (DE)
(74) Representative: Zimmermann, Gerd Heinrich

(57) **Abstract**

An evaporation crucible is described. The evaporation crucible includes: an electrically conductive chamber tube (120) having a wall such that an enclosure is formed, the chamber tube having a tube axis; a first electrical connection (162; 182); a second electrical connection; at least one feeding opening (134) ; and at least one distributor orifice (170; 470; 670) of the chamber tube, wherein the enclosure includes a melting-evaporation area

## Description

### FIELD OF THE INVENTION

The invention generally relates to thin-film forming apparatuses and crucibles used in evaporation apparatuses for thin film forming. Particularly, it relates to crucibles for evaporation of alloys or metals. Specifically it relates to an evaporation crucible and to an evaporation apparatus.

### BACKGROUND OF THE INVENTION

For thin-film coating of a material on a substrate, an evaporator can be used. For example, coatings with metal films, which e.g. provide a capacitor of a large panel display or a protective layer on a web, can be applied with evaporators. Specifically, for large panel displays, a substrate, which can be provided as a large and relatively thin glass plate, might be vertically positioned in a coating process and coated with a vertical evaporator.

Particularly for vertical evaporation, a source for a material vapor to be deposited on a substrate is commonly provided with a vertical nozzle pipe, which defines a linear vertically extending source for coating a vertically aligned substrate.

The linear sources provided thereby have a high complexity and are expensive to manufacture and to maintain.

Additionally, different temperature areas, which have been suggested for evaporation crucibles, can have an insufficient stability because the material to be evaporated can migrate in various areas of a crucible and can also dissolve portions of the crucible, whereby a temperature customization can be deteriorated.

### SUMMARY OF THE INVENTION

In light of the above, the present invention provides an evaporation crucible according to independent claims 1, 3 and 22, and an evaporation apparatus according to claim 24.

According to one embodiment, an evaporation crucible is provided. The evaporation crucible includes: an electrically conductive chamber tube having a wall forming an enclosure, the chamber tube having a tube axis; a first electrical connection; a second electrical connection, wherein the first and the second electrical connection being adapted for providing a heating current substantially parallel to the tube axis; at least one feeding opening; and at least one distributor orifice.

According to another embodiment, an evaporation crucible is provided. The evaporation crucible includes: an electrically conductive chamber tube having a wall forming an enclosure; at least two distributor orifices or a distributor orifice being slit-shaped shaped, the at least two distributor orifices or the distributor orifice being slit-shaped are formed in the wall of the chamber tube and define a preferential direction; a first electrical connection; a second electrical connection, wherein the first and the second electrical connection being adapted for providing a heating current substantially parallel to the preferential direction; and at least one feeding opening.

According to yet another embodiment, an evaporation crucible is provided. The evaporation crucible includes: an electrically conductive chamber tube having a wall such that an enclosure is formed, the chamber tube having a tube axis; a first electrical connection; a second electrical connection, wherein the enclosure includes a melting-evaporation area; at least one feeding opening ; and at least one distributor orifice.

According to another embodiment, an evaporation apparatus including at least one evaporation crucible is provided. The evaporation crucible includes: an electrically conductive chamber tube having a wall, the chamber tube having a tube axis; a first electrical connection; a second electrical connection, wherein the first and the second electrical connection being adapted for providing a heating current substantially parallel to the tube axis; at least one feeding opening; and at least one distributor orifice in the wall of the chamber

Further advantages, features, aspects and details that can be combined with the above embodiments are evident from the dependent claims, the description and the drawings.

Embodiments are also directed to apparatuses for carrying out the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates or is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:

Fig. 1 shows a schematic view of an evaporation crucible including electrical connections and a chamber tube according to the embodiments described herein;

Fig. 2 shows a schematic view of a further evaporation crucible including electrical connections and a chamber tube according to the embodiments described herein;

Fig. 3a shows a schematic view of an even further evaporation crucible including electrical connections and a chamber tube according to the embodiments described herein;

Figs. 3b and 3c show other schematic views of the evaporation crucible of Fig. 3a;

Figs. 4a to 4d show schematic views of evaporation crucibles, and illustrate different distributor orifices according to the embodiments described herein;

Fig. 5 shows a schematic view of an evaporation crucible including electric connections and several portions forming a chamber tube according to the embodiments described herein;

Figs. 6a to 6c show schematic views of evaporation crucibles including electric connections, a chamber tube and differently shaped distributor orifices according to embodiments described;

Fig. 7 shows a schematic view of an evaporation apparatus according to embodiments described herein including a plurality of evaporation crucibles;

Fig. 8 shows a schematic view of a further evaporation apparatus according to the embodiments described herein including a plurality of evaporation crucibles; and

Figs. 9a and 9b show schematic views of connections between chamber tube portions.

### DETAILED DESCRIPTION OF THE DRAWINGS

Without limiting the scope of the present application, in the following aluminum is mainly described as a material to be deposited on a substrate. The invention is also directed to metals, alloys or other materials to be evaporated and, e.g., used for the coating of a substrate. Further, without limiting the scope of the present invention, a substrate is typically referred to as a glass substrate as often used for display technology, e.g., displays. Embodiments of the present invention can be applied to thin-film vapor deposition on other substrates and for other technologies.

Without limiting the scope of the present application a cylinder is herein mainly described as a circular cylinder. A cylinder as claimed and as described herein can also be directed to other forms of cylinders like elliptical cylinders or cylinders based in geometrical shapes like squares, rectangles, triangles, pentagons or the like.

Within the following description of the drawings, the same reference numbers refer to the same components. Generally, only the differences with respect to the individual embodiments are described.

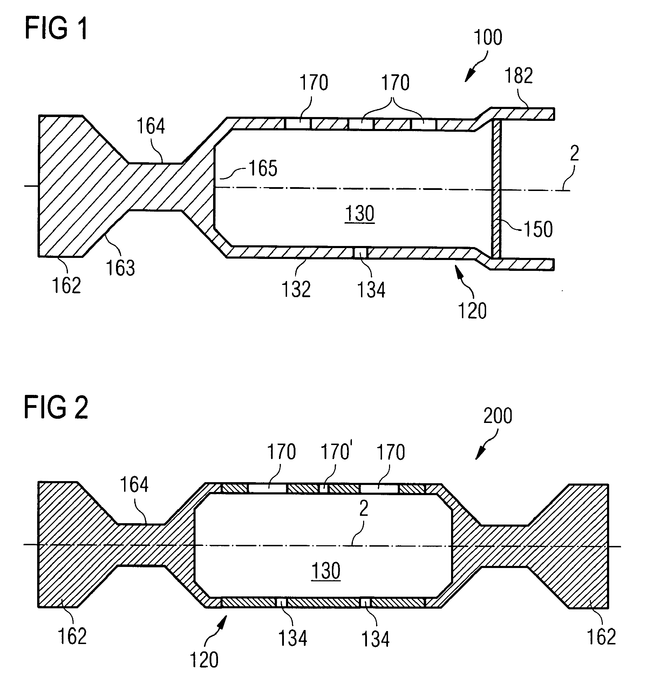

Fig. 1 shows an evaporation crucible 100. The evaporation crucible 100 includes a first electrical connection 162 and a second electrical connection 182. In-between the two electric connections a chamber tube 120 is provided. The chamber tube 120 includes a wall 132, which forms, e.g., a cylinder.

Fig. 1 illustrates embodiments wherein the evaporation crucible includes a chamber tube and first and second electrical connections being formed by a single-piece element. Embodiments described herein can be modified such that the evaporation crucible includes a chamber tube and the first and second electrical connection being formed as separate elements connected to each other.

According to one embodiment, the cylinder can be a circular cylinder. According to other embodiments described herein, the chamber tube 120 may also be provided as a cylinder based on other geometrical shapes. Thereby, according to other embodiments, also elliptical cylinders, oval cylinders or angular cylinders may be provided. The evaporation crucible 100 and the chamber tube 120, respectively have a tube axis 2. The tube axis 2 corresponds with the axis of the cylinder, that is, the tube axis is parallel to the height of the cylinder.

In Fig. 1, on the left side of the chamber tube 120, the first electrical connection 162 is provided. The electrical connection includes a connecting part, a cross-sectional area reducing portion 163 and a heating portion 164. Additionally, the cross-sectional area of the electrical connection 162 can be shaped by the recess 165. The first electrical connection 162 together with the second electrical connection 182 allow for passing the heating current through the chamber tube. As defined herein, the first and the second electrical connection being adapted for providing a heating current substantially parallel to the tube axis is to be understood such that in the chamber region the main current direction is parallel to the tube axis or the current flow in the area of the chamber tube, which includes one or more orifices 170, is substantially parallel to the tube axis 2. As a further example, in Fig. 1, the current flow in general can be described from left to right or vice versa (along the axis 2).

According to embodiments defined herein, the direction of the heating current is such that at least 70 % of the heating current flows parallel or substantially parallel to the tube axis within the chamber tube or within the area of the chamber tube including an orifice 170. Accordingly, currents flowing around openings in the chamber tube wall are a minority of the entire current flowing in the chamber tube.

Generally, the portions of the evaporation crucible can be, for example, provided as follows. Thereby, it is to be understood that the portions of the evaporation crucible can overlap or at least partly overlap with each other. The wide portion of the electrical connections 162 and 182 respectively, have a large cross-sectional area to provide a relatively low current density and, thereby, a relatively cool portion that can be in contact with e.g. connecting elements including copper. The cross-sectional area reducing portion 163 provides transition to the heating portion 164. The heating portion and the chamber tube have a smaller cross-sectional area as compared to the electrical connections. Thereby, the heating portion and the chamber tube are heated by the heating current. The cross-sectional area reducing portion 163 and the heating portion 164 provide a customization of the heat generation, which is conducted in the chamber tube for melting and evaporating material.

The connecting portion of the electrical connections may, according to further embodiments, also be formed by one or more protrusions, which extend radially outward with respect to the axis 2. Thereby, a clamp of a connecting element of an evaporation apparatus to contact an electrical connection of the evaporation crucible can contact the protrusion. As another example, a connection element 182 in Fig. 1 can be contacted by a pipe-clip-shaped connecting element of an evaporation apparatus to contact the electrical connection.

The material to be deposited is melted and evaporated by heating the evaporator crucible 100. Heating can be conducted by providing a power source (not shown) connected to the first electrical connection 162 and the second electrical connection 182. Thereby, heating is conducted by the current flowing through the body 120 of the crucible 100. Generally, within the regions having a smaller cross-sectional area, the resistance of the body of the evaporation crucible is increased. Thereby, the heating power can be calculated according to equation P=R I², wherein P is the power, R is the resistance and I is the current. As a result of the proportion between the resistance and the cross-sectional area, the temperature is increased in regions having a smaller cross-sectional area. Thus, it is possible to control the resistances of the different areas of the crucible such that desired temperatures are provided in the different areas. For example, the temperature in the melting-evaporation area in the chamber 130 can be in the range of 700°C to 1600°C or 1300°C-1600°C.

As another example, the temperature in the melting-heating area of the chamber 130 is above the evaporation temperature of the material to be deposited. However, a wire provided for feeding the material results in a local decrease in the temperature in a small portion of the melting-evaporation area. Accordingly, according to further embodiments, the temperature is at least 200°C above the evaporation temperature, e.g., 200°C to 900 °C or 600°C to 870 °C above the evaporation temperature. For example, for aluminum, the temperature can be above 900°C or above 1150 °C.

Typically, a lower limit of the temperature depends on the melting temperature of the material to be deposited and the chamber pressure. Typically, an upper limit of the temperature can be given by the temperature stability of the evaporation crucible.

According to further embodiments, the resistance of different areas of the evaporator crucible 100 can further be controlled by changing the material composition of the evaporator crucible.

Generally, according to embodiments described herein, the materials of the crucible should be conductive, the materials should be temperature resistant to the temperatures used for melting and evaporating, and the materials should be resistant with regard to the liquid materials or the material vapor, respectively. For example, liquid aluminum is highly reactive and can provide significant damage to crucibles for melting aluminum. According thereto, materials selected from the group consisting of a metallic boride, a metallic nitride, a non-metallic boride, a non-metallic nitride, nitrides, borides, graphite, TiB₂, a combination of TiB₂ and AIN, a combination of TiB₂ and BN, and combinations thereof can be used.

The difference in electrical resistivity of these materials can be used to further adapt the heat generation in the crucible. Thereby, the material composition in the different regions can be chosen to have a corresponding resistivity depending on the desired heat generation in the respective regions.

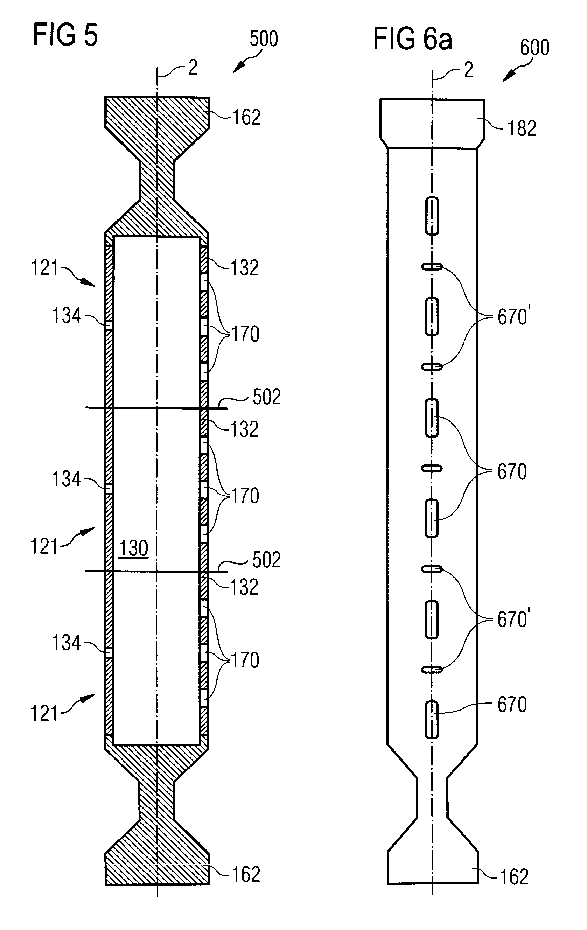

As show in Fig. 1, an opening 134 for feeding a wire of the material to be evaporated is provided in the wall of the chamber tube 120. As shown in Fig. 1, according to one embodiment, one feeding opening 134 can be provided in the chamber tube. According to other embodiments, (see, for example, Figs. 2 and 5), two, three or more openings 130 for feeding a material to be evaporated in the chamber tube can be provided.

Typically, the material to be evaporated can be fed into the chamber tube with a material wire passing through the opening. Thereby, the wire can be fed in the chamber at an inclined angle with respect to the chamber surface. Particularly for the inclined feeding, an inner portion of the heated chamber wall may be contacted with the wire. Thereby, the material of the wire is melted.

In Fig. 1, the chamber tube 120 is closed at both ends. At one end it is closed by the first electrical connection 162. At the other end it is closed by the cover 150, which is for example formed as a disk and which is provided in the second electric connection 182. Thereby, the closed chamber tube 120 forms an enclosure that provides a melting-evaporation area of the evaporation crucible 100. The chamber 130 includes openings for feeding the material and openings of the distributor orifices 170.

According to embodiments described herein, an distributor orifice is a distributor orifice of the chamber tube or distributor orifices are distributor orifices of the chamber tube.

According to embodiments described herein, the melting-evaporation area is closed to a maximum degree. Thus, only a small amount of vapor leaves the chamber in an undesired direction (e.g. in the direction of the opening for feeding the material).

Typically, a lower limit of the temperature depends on the melting temperature of the material to be deposited and the chamber pressure. Typically, an upper limit of the temperature can be given by the temperature stability of the evaporation crucible.

As shown in Fig. 1, according to embodiments described herein, chamber wall 132 of chamber 130 has a distributor orifice 170 through which the material vapor may leave the enclosure with a defined evaporation direction.

Vapor deposition of thin films may, for example, be applied for organic light emitted diodes (OLED), for other display devices (e.g. TFT), or generally for thin-film coating on glass substrates or foils. As an example, thin metal films are provided for display applications in order to control individual pixels of a display.

Typically, for applications providing a vapor deposition for vertically arranged substrates, a linear evaporator unit with a nozzle pipe, which redirects vapor emitted by an evaporation area of an elongated crucible, can be used. Thereby, the vertically arranged substrate can be transported past the linear evaporation apparatus in a horizontal direction for thin film coating of the substrate. However, the system of the nozzle pipe for redirecting the material vapor out of a vertical pipe along horizontal evaporation axes and the commonly used crucibles are complex and difficult to maintain. Since vertical substrate arrangement is desired in light of particle contamination and bending of the substrates, it is desirable to have a simplified evaporation source for vertical evaporation applications. Embodiments of evaporation crucibles described herein can be used as a linear source for a vertical evaporation apparatus.

Evaporation crucibles as described herein can be utilized for inline evaporation apparatuses for vertically transported substrate with a directed evaporation direction (e.g. line-shaped). The arrangement of the evaporation crucible can be simplified and, thereby, reduces costs. For example, this is due to the limited number of components requiring maintenance.

As a further example, the embodiments described herein can be utilized for the coating of substrates for display technology or the like. Thereby, substrate size may be as follows: A typical glass substrate and, thereby, also a coating area can have dimensions of about 0.7 mm x 370 mm x 470 mm. Yet, next generation substrates can have a size of about 1100 mm x 1300 mm or larger. For example, applications described herein refer typically to large substrates. Thereby, a large substrate can have a height and length of 500 mm or above. This can typically be 680 mm x 880 mm, 1100 mm x 1300 mm or larger in the case of glass substrates. Typical large flexible substrates, e.g., foils, can have a width of at least 500 mm.

According to the embodiments described with respect to Fig. 1, a cover 150 is provided at the electrical connection 182. Thereby, an enclosure including a melting-evaporation area is provided. The material to be evaporated, for example aluminum, is provided in the chamber through opening 134 and contacts a heated surface within the chamber.

Within the chamber, the material is melted and upon further heating evaporated in the melting-evaporation area. The material vapor leaves the chamber through distributor orifices 170 and can thereafter be deposited on a substrate.

According to even further embodiments, which might be combined with other embodiments herein, a distributor orifice can be provided with a channel length of 3 to 20 mm along an evaporation axis. According to even further embodiments, the width of the orifice is above 2 mm, for example, in the range of 5 to 6 mm. The length of a slit can, for example, be up to 80 mm or higher and might extend substantially along the axial length of the chamber tube.

According to different embodiments, the chamber has a dimension in the direction of the axis 2 in the range of 80 mm to 1500 mm, or even up to 2000 mm. According to further embodiments, the diameter of chambers can be in the range of 10 mm to 200 mm, or in the range of 20 mm to 50 mm.

According to embodiments described herein, the melting-evaporation area is to be understood as an area in which the material to be evaporated is melted and evaporated. Thereby, a one chamber system with similar pressure conditions within the chamber may be provided. Additionally or alternatively, other separation means for separating a melting area and an evaporation area within the chamber might, according to embodiments described herein, be omitted. Accordingly, problems with migration of the very thin liquid material films or problems with a timely variation of customized temperature profiles in light of dissolving of portions of the evaporation crucible can be prevented.

According to embodiments described herein, the melting zone (e.g., a surface) of the melting evaporation area is within the evaporation zone.

A melting zone within the evaporation zone can e.g., be understood as having a reduced gas pressure region within the evaporation zone, for example in the range of 10% or 20%, in the melting-evaporation-area.

A melting zone within the evaporation zone can, as another example, be understood as having the melting zone (e.g., a surface) within the main evaporation zone, that is, for example, the zone in which at least 50% or 75% of the evaporation is conducted.

Thereby, the possibility of a splashboard, a faceplate for controlling splashing or the like does not affect the functionality of the melting-evaporation area.

The evaporation crucible 100 includes an enclosure wherein the material to be deposited is melted and evaporated. If the material, for example aluminum, is provided by continuously feeding the material to be deposited with a feeding wire or pellets, an equilibrium can be maintained such that the amount of material in the system is substantially constant. Thereby, the amount of material inserted in the system is provided by the diameter and the feeding speed of the feeding wire. In order to provide an equilibrium, the amount of material which is evaporated from the evaporator crucible 100, and the amount of material fed in the system should be similar. The evaporation amount can additionally or alternatively be controlled by the heating current. Further, according to embodiments described herein, non-continuous feeding with a wire, pellets and the like can be realized.

As shown in Fig. 1, a cover 150 can be provided within the second electric connection 182. According to one embodiment, the cover 150 can be made of the non-conductive material. Thereby, it may include, e.g., BN, or the like. A nonconductive cover is passively heated by the adjacent portion of the crucible. However, even a conductive material of the cover 150 might not result in a current flowing through because the current flows parallel to the axis 2 such that different ends of the cover 150 would be substantially on the same potential. A conductive cover can include TiB2 or other materials, which are mentioned above with regard to the chamber tube. If according to further embodiments the same material is used for the cover and the chamber tube, thermal extension of the cover and the chamber tube can be more easily adapted.

According to embodiments described herein, the shape of the evaporation crucible can be designed to have different cross-sections. As shown in Fig. 1, the first electrical connection 162 itself may have a relatively large cross-sectional area. Adjacent thereto, a portion 163 is provided which reduces the cross-sectional area. Thereby, the current in the heating portion 164 is increased and, the heating portion is heated. The cross-sectional area of the chamber tube is similar to - or smaller than the cross-sectional area of the heating portion. Thereby, the chamber tube is heated for melting and evaporation of the material to be deposited. For example, the cross-sectional area and/or the resistivity of the chamber tube can differ between -30% to 30% of the cross-sectional area and/or the resistivity of the heating portion 164. By heating the chamber tube and heating regions adjacent to the chamber tube, a highly symmetrical heat generation in and around the chamber 130 can be provided.

The heating portions on both sides and adjacent to the chamber provide an improved symmetric heating as compared to only locally heating the chamber. By providing a heat generation in the chamber that is not extensive as compared to the heat generation in the adjacent heating portions 164 results in a more homogeneous temperature within the chamber and, thereby, the melting-evaporation area.

According to further embodiments, if for example the chamber tube in the form of a circular cylinder is provided, and the first electrical connection and the second electrical and connection are also rotational symmetric, a highly symmetric arrangement of an evaporation crucible can be realized. Thereby, besides the small irregularities of the openings 134 and the distributor orifices 170, a symmetric heat current distribution and a symmetric heating is provided.

According to an even further embodiment, if the distributor orifices 170 are provided on a straight line parallel to the chamber tube axis 2, a heat generation irregularity is only provided along one line on the cylinder wall 132.

Fig. 2 shows a further evaporation crucible 200. The evaporation crucible 200 includes a chamber tube 120 forming a chamber 130 together with the electrical connections. As shown in Fig. 2, an electrical connection 162 including a heating portion 164 can be provided on both sides of the chamber tube with regard to the direction of the tube axes 2.

Within the wall of the chamber tube 120 two openings 134 for feeding the material to be evaporated is provided. For example, the material can be inserted in the chamber 130 by a material wire.

Generally, for embodiments described herein, at least one feeding opening is provided. According to other embodiments, two or more feeding openings can be provided. According to even further embodiments, one or more of the feeding openings can be provided in the wall of the chamber tube, the electrical connection element 162, and/or the cover 150.

According to further embodiments, the feeding opening can be provided with a bushing (not shown) to insert the wire in the chamber through the bushing. According to an even further embodiment, which can be combined with the bushing or which can be provided separately, the opening in the chamber wall 132 is inclined with respect to the chamber wall. Thereby, the wire can be inserted towards the bottom of the chamber. According to an even further embodiment, the opening in the chamber wall is provided with a chamfered edge.

At another portion of the chamber tube (in Fig. 2 on the opposite sides of openings 134), the wall 132 includes three distributor orifices, 170 and 170' respectively. Thereby, two different shapes of distributor orifices are included along a straight line in the wall of the chamber tube. The different shapes of distributor orifices have a different evaporation rate of the vapor generated in the melting-heating area of the chamber 130. The different vapor distributions can be combined to provide a substantially homogeneous coating on a substrate.

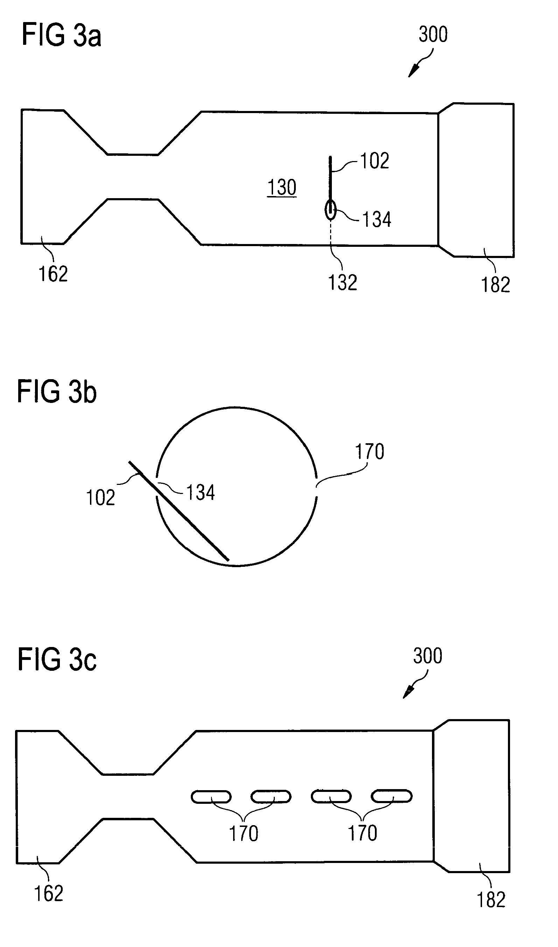

A further embodiment of an evaporation crucible 300 is explained with respect to Figs. 3a to 3c. Between the first electrical connection 162 and the second electrical connection 182 the chamber tube is provided. Figs. 3a to 3c show two different views of the chamber tube.

Fig. 3a shows an opening 134 for feeding a wire 102 into the chamber 130. As indicated by the oval shape of the sectional view of the opening 134, an, e.g., round bore in the wall 132 of the chamber tube is provided such that the inserted wire can be directed on the inner chamber wall of the chamber tube. A schematic further sectional side view is shown in Fig. 3b.

At a different portion of the chamber wall, the distributor orifices 170 are provided along a straight line in the wall of the chamber tube. According to other embodiments, the distributor orifices are not necessarily provided on a straight line, but may also be provided on two or more straight lines or may be arranged otherwise with regard to the chamber tube. As shown in Fig. 3c, according to an even further embodiment, the distributor orifices 170 are provided with a shape of rounded slits.

Accordingly, for embodiments described herein, two or more distributor orifices can be arranged arbitrarily, to be essentially on a straight line, or to be on a straight line. Thereby, a preferential direction of the two or more distributor orifices is defined by the straight line. Further, in the case of one distributor orifice being a slit, the long dimension of the slit can define the preferential direction of the distributor orifice.

Generally, for embodiments described herein, the heating current that is the majority of the heating current, e.g. at least 70 %, in the chamber tube or within the area of the chamber tube including an orifice 170 can be substantially parallel to the tube axis and/or to the preferential direction of the distributor orifice or of the distributor orifices, respectively.

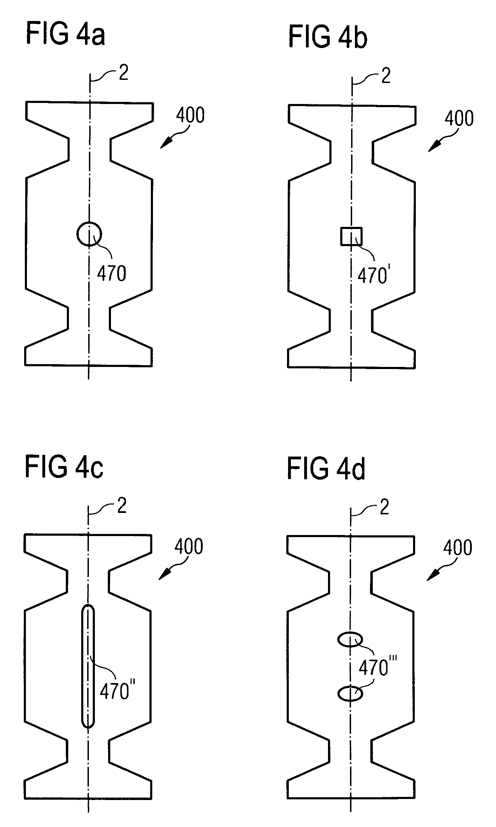

Further embodiments of distributor orifices will next be described with respect to Figs. 4a to 4d. In each of the figures an evaporation crucible 400 is shown. The crucibles have an axis 2, which is a tube axis of the chamber tube of the evaporation crucible. Thereby, for a cylinder tube, the axis 2 corresponds to the cylinder axis and/or the height of the cylinder.

Fig. 4a shows a circular distributor orifice 470. The distributor orifice can be provided as a symmetric bore in the wall of the chamber tube. According to other embodiments, the bore can be provided with chamfered edges or may be inclined with respect to the surface of the wall of the chamber tube. Thereby, an inclination towards the direction of axis 2 and/or perpendicular to axis 2 can be realized. According to a further embodiment, two or more distributor orifices 470 can be provided.

Fig. 4b shows a square distributor orifice 470'. Similarly to the orifice described with respect to Fig. 4a, a plurality of embodiments can be formed by modifying or combining one or more of the above described embodiments of an orifice with the square shaped orifice of Fig. 4b. In Fig. 4b, according to an even further embodiment, it is further possible to have rounded corners at the distributor orifices. Further, the square shown in Fig. 4b can also be formed as a rectangle. Thereby, for example, a slit 470" as shown in Fig. 4c can be provided. As already mentioned above, edges of the slit forming the distributor orifice 470" can be chamfered, or the direction with respect to the axis 2 of the evaporation crucible can be inclined. As described above, an inclination is to be understood such that a bore axis in the chamber wall is not perpendicular to the chamber wall at the respective position. According to further embodiments, two or more distributor orifices 470' or 470" can be provided.

Fig. 4d shows an evaporation crucible 400 including two distributor orifices 470'''. Contrary to the embodiments shown with respect to Fig. 3c, the longer axes of the oval shaped distributor orifices 470''' are perpendicular to the tube axis 2.

According to the embodiments of orifices described above, an evaporation distribution is provided that can be customized by the shape, the diameter, the bore in the wall, and by the wall thickness, which defines a length along the directional evaporation axis of the orifice. According to different embodiments, the shape of the distributor orifice can be round, oval, elliptical, angular, cylindrical, slit shaped, or formed in another way. According to yet another embodiment, which might be combined therewith, the direction of the bore can be horizontal or inclined with respect to the chamber wall surface. Further, it is additionally or alternatively possible to have the edges of the bore chamfered.

According to even further embodiments, which might be combined with other embodiments herein, a distributor orifice can be provided with a channel length of 3 to 20 mm along an evaporation axis. According to even further embodiments, the width of the orifice is above 2 mm, for example, in the range of 5 to 6 mm. The length of a slit can, for example, be up to 80 mm or higher and might extend substantially along the axial length of the chamber tube.

A further evaporation crucible 500 is shown in Fig. 5. Therein, two electric connections 162 are provided. Further, there are three chamber tube portions 121 which are combined with each other to form a chamber 130. Each of the chamber tube portions 121 have three distributor orifices 170 and an opening for feeding the material to be evaporated. The connections between the chamber tube portions are indicated by dashed lines 502.

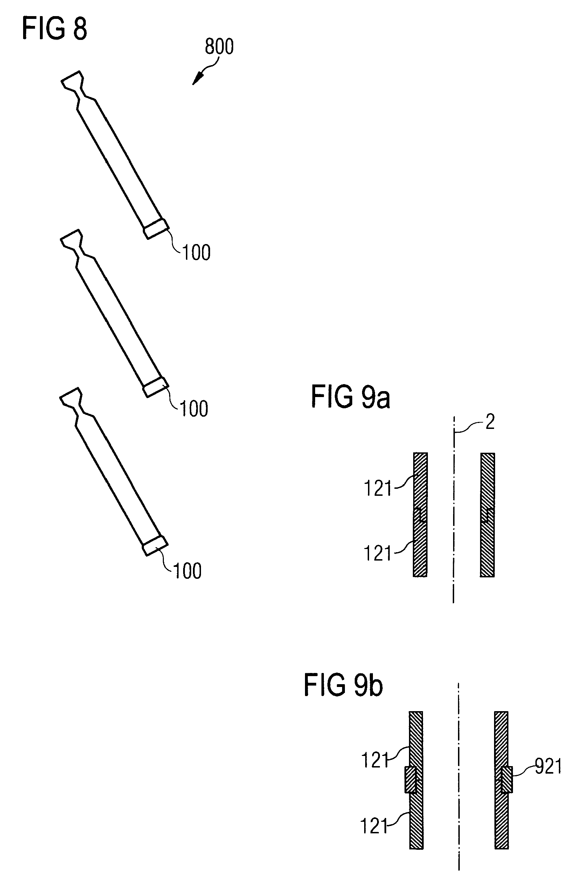

According to one embodiment, the connections between the electrical connections and the first chamber tube portion can be realized by a step like or groove like (tongue and groove connections) centering element in one or both of the components to be connected. Fig. 9a shows portions 121 of a chamber tube, which are connected with a step-like connection. Thereby, according to one embodiment, both chamber tube portions 121 have step-like cross-section such that the chamber tube portions 121 match each other for a connection.

In some embodiments described herein, the chamber tube and the first and second electrical connection are formed as separate elements connected to each other. Thus, with regard to Figs. 9a and 9b, according to a further embodiment, a similar connection can be provided between the chamber tube and one or both of the electrical connections. Thus, the step-like or groove-like connection may also be applied for a connection utilized in the above described embodiments between chamber tube and an electrical connection. Generally, the connection should be adapted for having the heating current trespass through the connection in the direction of the optical axis 2. Nevertheless, embodiments described herein can also be yielded by a modification such that the chamber tubes and first and second electrical connections are formed by a single-piece element.

According to different embodiments, a connection between chamber portions or between a chamber portion and a connection element can also be realized as shown in Fig. 9b. Therein, a step is provided in the adjacent portions 121 and a ring 921 is provided for the connection. According to different embodiments, the ring can protrude radially outward with regard to the chamber (see Fig. 9b) or the ring can be flush with the wall of the portions (not shown). According to an even further embodiment, the ring can be formed from a non-conductive material.

Fig. 6a shows a further evaporation crucible 600. The evaporation crucible 600 includes a first electric connection 162 at a chamber tube end and a second electric connection 182 at another chamber tube end. The electrical connection, the chamber tube, and the other electrical connection are arranged in this order along the direction of the axis of the chamber tube. As shown in Fig. 6a, a plurality of first distributor orifices 670 and a plurality of second, different distributor orifices 670' can be provided. According to different embodiments, any combination of distributor orifice embodiments can be combined for a chamber tube. Thereby, two, three or more different orifice embodiments may be used.

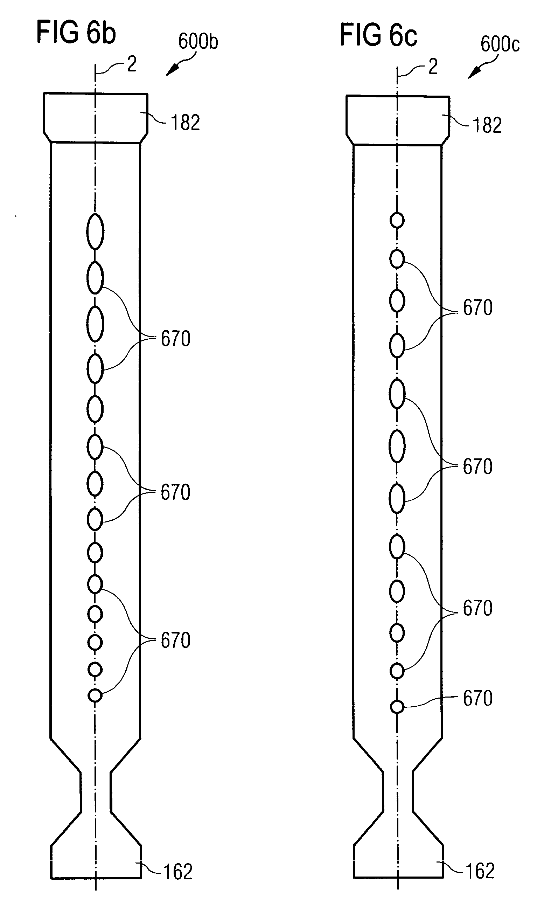

According to even further embodiments (see Figs. 6b and 6c) the size and or the shape of the orifices can vary along the direction of the chamber tube. Fig. 6b shows an embodiment, wherein the size of the orifices increases towards the top of the evaporation crucible. As an example, a reduce vapor pressure in the upper regions of the crucible can be compensated by such an arrangement. Fig. 6c shows an embodiment wherein the size of the orifices increases towards the center of the evaporation crucible. Thereby, reduced vapor pressure regions may be compensated for or, more generally, a distribution of the evaporated material can be adapted. Generally, for embodiments described herein, different numbers, sizes, shapes, and arrangement of orifices can be combined with any of the embodiments described herein.

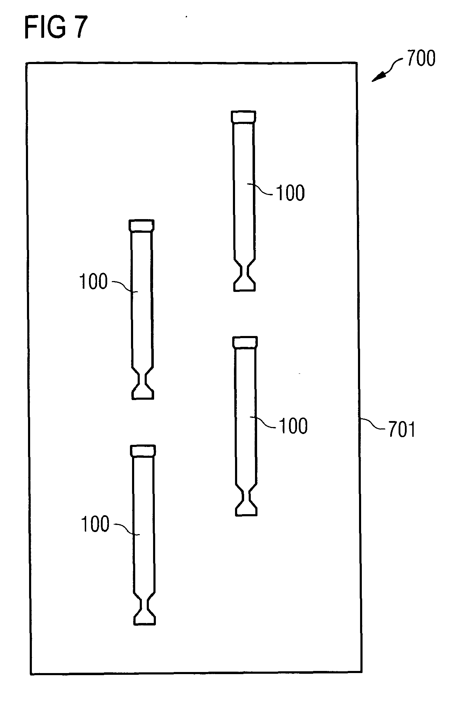

Fig. 7 shows an evaporation apparatus 700. The evaporation apparatus includes a housing 701. Therein, four evaporation crucibles 100 are shown. The evaporation apparatus 700 is particularly useful for evaporation of large vertically arranged substrates. However, it may also be used for horizontally-arranged substrates. According to the increasing size of substrate dimensions, evaporation crucibles 100 or some of the evaporation crucibles 100 can be stacked above each other in order to provide an enlarged evaporation area. As shown in Fig. 7, two of the stacked couples of evaporation crucibles are provided next to each other in an overlapping manner. According to different embodiments, a plurality of evaporation crucibles can be used in an evaporation apparatus. Thereby, it is additionally, possible to provide a group of two, three or more evaporation crucibles along an axis and to have several groups of evaporation crucibles next to each other, e.g. in an overlapping manner as shown in Fig. 7.

As an exemplary embodiment, a method of forming a thin film with an evaporation crucible described herein can be carried out by using an apparatus which is entirely placed in a vacuum atmosphere of 10⁻² to 10⁻⁶ mbar. Thereby, the thin film can be vapor deposited on a substrate or a carrier foil without contamination of particles from the ambient atmosphere.

According to embodiments described herein, a method of evaporating a material includes: providing a chamber with a melting-evaporation area, and inserting a solid material to be evaporated in the melting-evaporation area.

A further arrangement of evaporation crucibles 100 in an evaporation apparatus 800 is shown in Fig. 8. Therein, the axis of the evaporation crucibles, that is the axes 2, is inclined by about 30°. According to a further embodiment, other angles, e.g. 10 to 45°, may be realized.

It is further possible that within one crucible, distributor orifices are also inclined with respect to the tube axis. Thereby, they can be vertically or horizontally arranged in spite of the inclination of the crucible itself. According to a further embodiment, the rotated distributor orifices may, however, still be provided on a straight line. According to embodiments described herein, in which distributor orifices are arranged along a straight line that is parallel to the tube axis of the evaporation crucible, the influence of the distributor orifices on the heating current distribution is minimized.

Evaporation crucibles as described herein can be utilized for inline evaporation apparatuses for vertically transported substrate with a directed evaporation direction (e.g. line-shaped). The arrangement of the evaporation crucible can be simplified and, thereby, reduces costs. For example, this is due to the limited number of components requiring maintenance.

According to embodiments described herein, a chamber tube is provided which is closed at the axial ends of the tube by two elements, each selected from the group consisting of: a cover and an electrical connection. The one or more openings for feeding a material to be evaporated and one or more distributor orifices are provided in the wall of the chamber tube. According to different, further embodiments, the distributor orifices can be formed and arranged with various forms and dimensions, such as one slit, a plurality of shorter slits, a plurality of bores, and the like. Thereby the distribution of the emitted vapor can be influenced. Thus, the necessity for distribution controlling apertures can be reduced.

The evaporation crucibles according to embodiments described herein, which are easy to manufacture and maintain, can be used at different orientations, that is vertical, horizontal, or at other orientations there between. According to other embodiments, the vapor beam is directed along a directional evaporation axes to better control the distribution of the vapor.

While the foregoing is directed to embodiments of the invention, other and further embodiments of the invention may be devised without departing from the basic scope thereof, and the scope thereof is determined by the claims that follow.

## Claims

1. Evaporation crucible comprising:
an electrically conductive chamber tube (120) having a wall forming an enclosure, the chamber tube having a tube axis (2);
a first electrical connection (162; 182);
a second electrical connection (162; 182), wherein the first and the second electrical connection being adapted for providing a heating current substantially parallel to the tube axis;
at least one feeding opening (134) ; and
at least one distributor orifice (170; 470; 670).

2. Evaporation crucible according to claim 1, wherein portions of the wall of the chamber tube (120) form a cylinder and wherein the tube axis is provided in the direction of the height of the cylinder.

3. Evaporation crucible comprising:
an electrically conductive chamber tube (120) having a wall forming an enclosure;
at least two distributor orifices (170; 470; 670) or a distributor orifice being slit-shaped, the at least two distributor orifices or the distributor orifice (170; 470; 670) being slit-shaped are formed in the wall of the chamber tube and define a preferential direction;
a first electrical connection (162; 182);
a second electrical connection (162; 182), wherein the first and the second electrical connection being adapted for providing a heating current substantially parallel to the preferential direction; and
at least one feeding opening (134).

4. Evaporation crucible according to any of the preceding claims, wherein the enclosure comprises a melting-evaporation area;

5. Evaporation crucible according to any of the preceding claims, wherein the feeding opening (134) is located in the wall of the chamber tube (120).

6. Evaporation crucible according to any of the preceding claims, wherein the first electrical connection (162; 182) is located with regard to the tube axis (2) direction on one side of the chamber tube and wherein the second electrical connection (162; 182) is located with regard to the tube axis direction on another side of the chamber tube.

7. Evaporation crucible according to any of the preceding claims, further comprising:
at least one cover forming an enclosure with the chamber tube.

8. Evaporation crucible according to any claim 1 to 2, wherein the at least one distributor orifice (170; 470; 670) is a bore in the wall of the chamber tube.

9. Evaporation crucible according to any of the preceding claims, wherein the at least one distributor orifice are at least three distributor orifices.

10. Evaporation crucible according to claim 9, wherein the at least three distributor orifices are arranged to define a preferential direction.

11. Evaporation crucible according to claim 10, wherein the preferential direction is parallel to at last an element selected from the group consisting of: the tube axis (2) and the heating current direction.

12. Evaporation crucible according to any of the preceding claims, wherein at least one distributor orifice (170; 470; 670) is slit-shaped or circular-shaped

13. Evaporation crucible according to any of the preceding claims, further comprising:
at least one further feeding opening (134)

14. Evaporation crucible according to any of the preceding claims, wherein the chamber tube (120) is formed by several tube elements arranged one behind the other in a direction of the tube axis (2).

15. Evaporation crucible according to any of the preceding claims, further comprising:
a first heating portion provided adjacent to the chamber tube and between the chamber tube and an electrical connection of the first and the second electrical connection (162; 182).

16. Evaporation crucible according to claim 15 wherein the heating portion has a cross-sectional area smaller than the cross-sectional area of the electrical connection.

17. Evaporation crucible according to any of the preceding claims, wherein the chamber tube (120) includes at least one material selected from the group consisting of: a metallic boride, a metallic nitride, a metallic carbide, a non-metallic boride, a non-metallic nitride, a non-metallic carbide, nitrides, borides, graphite, TiB2, BN, and combinations thereof.

18. Evaporation crucible according to any of the preceding claims, wherein the distributor orifice defines an evaporation axis, and wherein the evaporation axis is substantially horizontal.

19. Evaporation crucible according to any of the preceding claims, wherein the distributor orifice defines an evaporation axis, and wherein the evaporation axis is directed upwardly.

20. Evaporation crucible according to any of the preceding claims, wherein the distributor orifice defines an evaporation axis, and wherein the distributor orifice has a length along the evaporator axis of 3 mm to 20 mm.

21. Evaporation crucible according to any of the preceding claims, wherein the width of the distributor orifice is at least 2 mm.

22. Evaporation crucible comprising:
an electrically conductive chamber tube (120) having a wall such that an enclosure is formed, the chamber tube having a tube axis (2);
a first electrical connection (162; 182);
a second electrical connection (162; 182);
at least one feeding opening (134); and
at least one distributor orifice (170; 470; 670),
wherein the enclosure comprises a melting-evaporation area.

23. Evaporation crucible according to claim 22, wherein the first and the second electrical connection being adapted for providing a heating current substantially parallel to the tube axis.

24. An evaporation apparatus, comprising:
at least one evaporation crucible (100; 200; 300; 400; 500; 600; 600a/b) according to any of the preceding claims.

25. Evaporation apparatus according to claim 24, comprising:
at least two evaporation crucibles according to any of the preceding claims.

26. Evaporation apparatus according to any of claims 24 to 25, wherein the at least one evaporation crucible is arranged with the tube axis being vertical.
